# EUROPÄISCHE PATENTANMELDUNG

(11) **EP 0 964 586 A2**
(43) Veröffentlichungstag der Anmeldung: **15.12.1999**
(21) Anmeldenummer: 98123781.1
(22) Anmeldetag: 15.12.1998
(51) Int. Cl.: H04Q 1/14

(54) **Gehäuse für eine kleine Telekommunikationsanlage**

(30) Priorität: 08.06.1998 DE 29810260 U
(71) Anmelder: DeTeWe - Deutsche Telephonwerke Aktiengesellschaft & Co., 10997 Berlin (DE)
(72) Erfinder: Krämer, Katharina, 12047 Berlin (DE); Krispin, Harro, 13503 Berlin (DE); Pütz, Peter, 12103 Berlin (DE); Schulz, Jürgen, 12107 Berlin (DE)

(57) **Zusammenfassung**

Die Erfindung beschreibt ein Gehäuse für eine kleine Telekommunikationsanlage, bestehend aus einem Gehäuseunterteil zur Aufnahme von auf Leiterplatten montierten vermittlungs- und energieversorgungstechnischen Baugruppen und einer Haube. Das Gehäuseunterteil besteht aus einer Wanne (10) und einer Abdeckung (20), wobei die Abdeckung (20) der Festhaltung der Leiterplatte (30) dient.

## Beschreibung

Die Erfindung betrifft ein Gehäuse für eine kleine Telekommunikationsanlage, bestehend aus einem Gehäuseunterteil zur Aufnahme von auf Leiterplatten montierten vermittlungs- und energieversorgungstechnischen Baugruppen und einer Haube.

Für Telekommunikationsanlagen ist ein Aufbau der vermittlungstechnischen Baugruppen in mehreren Ebenen übereinander angeordneter Leiterplatten bekannt (DE 37 37 058 C1, DE 73 15 519 U1). Stützfüße, Halterungen und Abwinkelungen im Gehäuse dienen als tragende Elemente für die Leiterplatten. Hierbei sind die Halterungen und Abwinkelungen durch Ausstanzen und Biegen von Trägerteilen des aus Blech geformten Gehäuses entstanden.

Beim Einsatz von Kunststoffgehäusen sind entsprechende Ausformungen vorzusehen. Diese lassen sich teilweise nur unter Verwendung teurer Werkzeuge in komplizierten Verfahrensschritten herstellen. Außerdem ist bei einer geforderten engen Packungsdichte von Bauelementen auf den Leiterplatten für eine genügend große Luftzirkulation an den Bauelementen zur Wärmeabfuhr zu sorgen und nach dem heutigen "plug and play"-Prinzip eine weitgehend selbständige Installation durch den Nutzer in einfacher Weise zu gewährleisten.

Der Erfindung lag die Aufgabe zugrunde, ein Aufbaukonzept für Telekommunikationsanlagen, insbesondere für kleine Vermittlungsanlagen, zu entwickeln, das eine kompakte Bauweise bei optimaler Luftzirkulation gestattet, unter Verwendung ausschließlich von Kunststoffteilen für das Gehäuse, das sich für einen Zusammenbau ausschließlich durch Automaten eignet und das einen einfachen Endgeräteanschluß durch den Nutzer gestattet.

Diese Aufgabe ist durch die Erfindung gelöst, wie sie im Kennzeichnungsteil des Anspruches 1 dargelegt ist. Weitere vorteilhafte Ausgestaltungen sind Gegenstand der Unteransprüche.

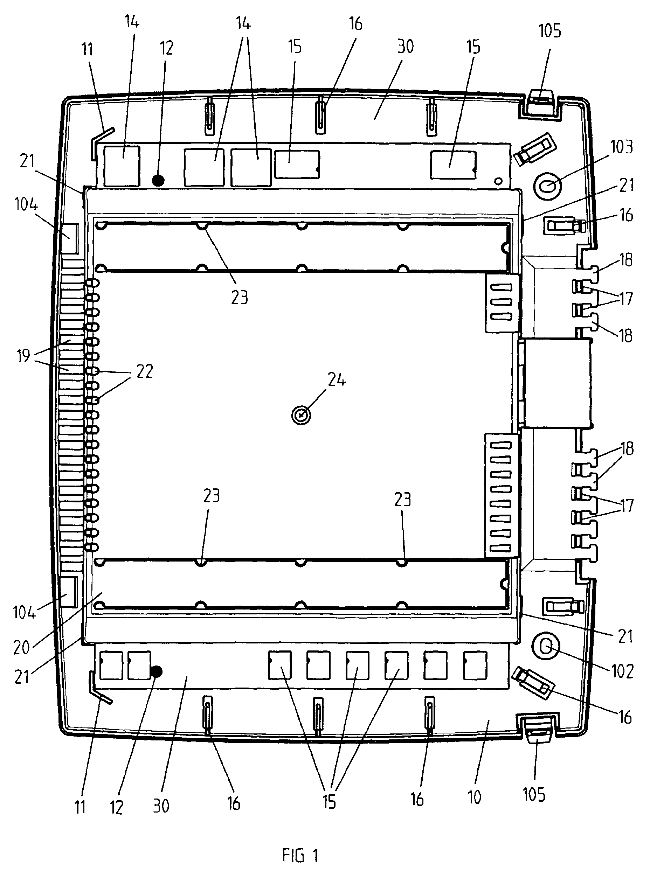

Die Erfindung wird anhand einer aus zwei Figuren bestehenden Zeichnung näher beschrieben. Darin zeigt die
- Fig. 1: die Aufsicht auf die Telekommunikationsanlage bei abgenommener Haube und die

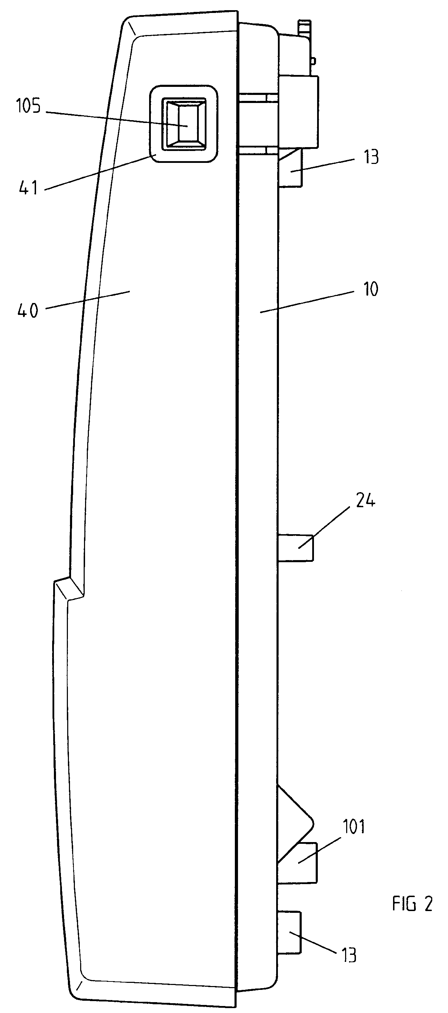

- Fig. 2: die Seitenansicht der Telekommunikationsanlage.

In beiden Figuren tragen dieselben Baugruppen, Ausformungen und Teile gleiche Bezugszeichen.

Das Gehäuseunterteil setzt sich aus einer Wanne 10 und einer Abdeckung 20 zusammen. Die Wanne 10 dient der Aufnahme der Leiterplatte 30, die durch die Abdeckung 20 in ihrer Lage festgehalten wird. Zu diesem Zweck sind weiterhin stumpfwinklige Stege 11 als Anschläge und Fixierdome 12 vorgesehen. Die Abdeckung 20 wird mittels federnder Rastnasen 21, die in rechteckige Schächte 13 der Wanne 10 greifen, mit der Wanne 10 verrastet. Dadurch ist die Leiterplatte 30 unverrückbar in ihrer Lage fixiert, wobei die in ihrem Randbereich angeordneten Buchsen 14 und Klemmverbinder 15 für den Anschluß der Endgeräte frei zugänglich sind.

Zur Festlegung der Kabel der angeschlossenen Endgeräte sind hakenförmige Niederhalter 16 in der Wanne 10 vorgesehen.

Außerdem dienen kammförmige Durchbrüche 17 in Verbindung mit zu den Kammlücken rechtwinklig angeordneten Stegen 18 der Zugentlastung der Endgerätekabel.

Weiterhin sind sowohl in der Wanne 10 als auch in der Abdeckung 20 Lüftungaschlitze 19, 22 und Lüftungsöffnungen 23 zur Wärmeabfuhr vorgesehen, die bei einer Wandmontage der Telekommunikationsanlage in vertikaler Richtung eine Kaminwirkung durch Ansaugen der Luft durch die kammförmigen Durchbrüche 17 hervorrufen. Die Abdeckung 20 kann mit einer versiegelbaren Schraube 24 mit der Wanne 10 verschraubt werden.

Zur Wandmontage der Telekommunikationsanlage sind drei Dome 101, 102, 103 vorgesehen, die am Boden der Wanne 10 jeweils an den Ecken eines gleichseitigen Dreiecks angeordnet sind. Dabei ist der in der montierten Befestigungsstellung obere Dom 101 geschlitzt ausgeführt und die beiden anderen Dome 102, 103 weisen um 90° versetzte Langlöcher auf.

Die Telekommunikationsanlage wird durch eine Haube 40 geschlossen. Die Haube 40 weist zwei nicht dargestellte Haken auf, die in Hohlschächte 104 der Wanne 10 greifen. Zwei seitliche Rasthaken 105 der Wanne 10 rasten in Lochungen 41 der Haube 40 ein.

## Patentansprüche

1. Gehäuse für eine kleine Telekommunikationsanlage, bestehend aus einem Gehäuseunterteil zur Aufnahme von auf Leiterplatten montierten vermittlungs- und energieversorgungstechnischen Baugruppen und einer Haube, dadurch gekennzeichnet, daß das Gehäuseunterteil aus einer Wanne (10) und einer Abdeckung (20) besteht, wobei die Abdeckung (20) der Festhaltung der Leiterplatte (30) dient.

2. Gehäuse nach Anspruch 1, dadurch gekennzeichnet, daß stumpfwinklige Stege (11) in Verbindung mit Fixierdome (12) die Lage der Leiterplatte (30) in der Wanne (10) festlegen.

3. Gehäuse nach Anspruch 1, dadurch gekennzeichnet, daß die Abdeckung (20) mittels federnder Rastnasen (21) in Schächten (13) der Wanne (10) fixiert ist.

4. Gehäuse nach Anspruch 1, dadurch gekennzeichnet, daß die Wanne (10) hakenförmige Niederhalter (16) und kammförmige Durchbrüche (17) mit Stegen (18) zur Führung und Zugentlastung der angeschlossenen Kabel von Endgeräten aufweist.

5. Gehäuse nach Anspruch 1 und 3, dadurch gekennzeichnet, daß die Wanne (10) und die Abdeckung (20) Lüftungsschlitze (19, 22) und Lüftungsöffnungen (23) aufweisen.

6. Gehäuse nach Anspruch 1 und 3, dadurch gekennzeichnet, daß die Abdeckung (20) durch eine versiegelbare Schraube (24) zusätzlich mit der Wanne (10) verschraubt ist.

7. Gehäuse nach Anspruch 1, dadurch gekennzeichnet, daß die Wanne (10) und Haube (40) über Haken und Rasthaken (105) miteinander verbunden sind.
